# EUROPÄISCHE PATENTSCHRIFT

(11) **EP 1 855 512 B1**
(45) Veröffentlichungstag und Bekanntmachung des Hinweises auf die Patenterteilung: **08.06.2011**
(21) Anmeldenummer: 07105046.2
(22) Anmeldetag: 27.03.2007
(51) Int. Cl.: H05K 1/14, H05K 3/36, H01R 12/51

(54) **Anordnung einer Leiterplatte und einem dazu in einem festen Abstand gehaltenen Kontaktträger**
Assembly of a circuit board and a contact support which is held in a fixed spacing thereto
Assemblage d'un support de circuit et d'un support de contact tenu à distance fixe de celui-ci

(30) Priorität: 11.05.2006 DE 102006022107
(43) Veröffentlichungstag der Anmeldung: 14.11.2007
(73) Patentinhaber: Siemens Aktiengesellschaft, 80333 München (DE)
(72) Erfinder: Petricek, Martin, 2020 Hollabrunn (AT)

(56) Entgegenhaltungen:
- US-A- 4 742 385
- US-A- 5 345 366
- US-A1- 2002 016 092

## Beschreibung

Die Erfindung betrifft eine Anordnung einer Leiterplatte und einem dazu in einem festen Abstand gehaltenen Kontaktträger, bei welcher eine dem Kontaktträger zugewandte Anschlussfläche der Leiterplatte mit einem an dem Kontaktträger ausgebildeten Gegenkontakt mittels einer Kontaktbrücke elektrisch leitend verbunden ist.

Kontaktbrücken für die Verbindung von Leiterplatten mit anderen Kontaktträgern sind nach dem Stand der Technik in unterschiedlichen Ausführungen bekannt. Im einfachsten Fall kommen Stecker und Kabel zum Einsatz, wobei sich solche Verbindungen nur für die Übertragung geringer Leistungen und für geringe Anforderungen hinsichtlich Störemissionen und Beständigkeit eignen. Insbesondere für Geräte der Leistungselektronik wie z.B. Wechselrichter oder Stromversorgungen kennt man deshalb im Wesentlichen starre Kontaktbrücken, die einerseits hohe Ströme übertragen und andererseits dauerhafte Kontaktstellen gewährleisten. Solche zumeist stabförmige Kontaktbrücken werden in der Regel auf eine Anschlussfläche der Leiterplatte gelötet und bei der Gerätemontage mit einem Gegenkontakt auf einem im festen Abstand zur Leiterplatte angeordneten Kontaktträger verbunden.

Die DE 695 08 046 T2 beschreibt als Stifte ausgebildete Kontaktbrücken, welche einen Kreuzquerschnitt aufweisen und mit den ersten Enden auf Anschlussflächen einer Leiterplatte gelötet sind. Die zweiten Enden der Stifte sind in Durchführungen einer weiteren Leiterplatte eingepasst. Nachteilig ist dabei, dass für die Herstellung der Lötverbindung eine Haltevorrichtung notwendig ist, welche die Stifte in Position hält. Beim als Durchführung ausgebildeten Gegenkontakt muss dieser durchkontaktiert sein.

In der US 6 354 845 B1 ist eine zylindrische Kontaktbrücke mit spiralförmigem Querschnitt zur Verbindung zweier Leiterplatten angegeben. Hier ist ebenfalls ein Lötvorgang zur Verbindung der Kontaktbrücke mit einer Anschlussfläche notwendig. Der Gegenkontakt ist als Durchkontaktierung einer zweiten Leiterplatte ausgebildet.

Die EP 1 524 893 A1 beschreibt einen Aufbau zweier Leiterplatten, die mit federnden Kontaktbrücken verbunden sind. Die ersten Enden der Kontaktbrücken sind dabei mit Anschlussflächen der ersten Leiterplatte verlötet. Im montierten Zustand sind die Leiterplatten mittels zusätzlicher Verbindungselemente im festen Abstand zueinander gehalten, wodurch die federnden Kontaktbrücken auf die Gegenkontaktflächen der zweiten Leiterplatte gedruckt sind.

Eine Anordnung gemäß dem Oberbegriff von Anspruch 1 wird in US 5 345 366 offenbart.

Der Erfindung liegt die Aufgabe zugrunde, für eine Anordnung der eingangs genannten Art eine Verbesserung gegenüber dem Stand der Technik anzugeben.

Erfindungsgemäß wird diese Aufgabe gelöst durch eine Anordnung einer Leiterplatte und einem dazu in einem festen Abstand gehaltenen Kontaktträger, bei welcher eine dem Kontaktträger zugewandte Anschlussfläche der Leiterplatte mit einem an dem Kontaktträger ausgebildeten Gegenkontakt mittels einer Kontaktbrücke elektrisch leitend verbunden ist und wobei die Kontaktbrücke als Kunststoffteil mit wenigstens einem von diesem Kunststoffteil gehaltenen Drahtelement ausgebildet ist und wobei des Weiteren ein Ende des wenigstens einen Drahtelements auf einer Stirnfläche des Kunststoffteils aufliegt. Zudem ist der Kunststoffteil mit der Leiterplatte in der Weise mittels einer Verschraubung verbunden, dass das Ende des wenigstens einen Drahtelements zwischen Stirnfläche des Kunststoffteils und Anschlussfläche der Leiterplatte geklemmt ist.

Nach der Erfindung ist der auf der Stirnfläche aufliegende Abschnitt des Drahtelements in eine entsprechende Vertiefung auf der Stirnfläche des Kunststoffteils eingeschnappt. Das Drahtelement ist dann auf einfache Weise im gebogenen Zustand außen am Kunststoffteil montierbar.

Diese einfach aufgebaute Anordnung ermöglicht eine stabile elektrische Verbindung zwischen einer Leiterplatte und einer in festem Abstand zu dieser angeordneten Kontaktplatte, wobei kein Lötvorgang und keine Durchkontaktierung erforderlich sind.

In einer vorteilhaften Ausprägung der Erfindung ist der Kontaktträger als zweite Leiterplatte ausgebildet. Dabei kann es sich um ein Submodul handeln, welches in einem Abstand zur ersten Leiterplatte angeordnet ist. Die Montage eines solchen Submoduls erfolgt dann in einfacher Weise durch Fixierung mittels Verschraubung, ohne dass zusätzliche Verbindungselemente erforderlich sind.

Eine andere vorteilhafte Ausprägung der Erfindung sieht vor, dass der Kontaktträger als Gehäuse ausgebildet ist. Die Kontaktbrücke dient dann einerseits zur Fixierung der Leiterplatte im Gehäuse und andererseits zur sicheren elektrischen Verbindung mit einem Gegenkontakt am Gehäuse. Dieser Gegenkontakt kann beispielsweise ein Anzeigeelement oder ein Erdungsanschluss sein.

Für die Ausführung der Anordnung ist es von Vorteil, wenn versetzt zur Symmetrieachse der Verschraubung aus der Stirnfläche des Kunststoffteils ein Fortsatz herausragt, welcher in einer Bohrung der Leiterplatte gehalten ist. Der Kunststoffteil ist somit gegen Verdrehen gesichert, sodass während eines Schraubvorgangs keine weitere Fixierung erforderlich ist.

Die Verschraubung ist vorteilhaft in der Weise ausgebildet, dass im Bereich der Anschlussfläche der Leiterplatte eine Schraube durch die Leiterplatte geführt ist und in eine an der Stirnseite des Kunststoffteils angeordnete Bohrung geschraubt ist. Damit wird sowohl der Kunststoffteil als auch die Anschlussbohrung in der Leiterplatte einfach herstellbar, wobei als Verbindungselement eine Schraube für Kunststoff zum Einsatz kommt.

Von Vorteil ist es zudem, wenn die Anschlussfläche der Leiterplatte mit Zinn überzogen ist. Die elektrische Verbindung ist dann besonders beständig und es wird einer möglichen Korrosion vorgebeugt.

Eine weitere günstige Ausführungsform sieht vor, dass die Verbindung der Kontaktbrücke mit der Leiterplatte und die Verbindung der Kontaktbrücke mit dem Kontaktträger gleichartig ausgebildet sind. Somit ist weder für die Anschlussfläche noch für den Gegenkontakt ein Lötvorgang oder ein durchkontaktierter Durchbruch erforderlich. Die Montage gestaltet sich einfach und es ist keine zusätzliche Fixierung zwischen Leitungsplatte und Kontaktträger notwendig.

Die Erfindung wird nachfolgend in beispielhafter Weise unter Bezugnahme auf die beigefügte Figur erläutert. Es zeigt in schematischer Darstellung:

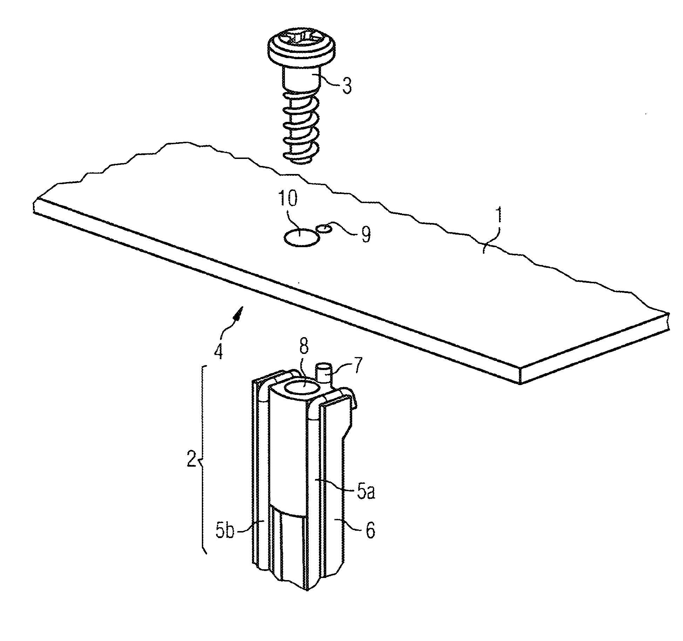

Fig. 1 Explosionsdarstellung für die Verbindung der Kontaktbrücke mit der Leiterplatte

In der Figur ist eine Leiterplatte 1 dargestellt. An der Unterseite der Leiterplatte 1 ist eine nicht sichtbare Anschlussfläche 4 angeordnet, die beispielsweise über Leiterbahnen mit nicht dargestellten Schaltungselementen verbunden ist. Die Anschlussfläche 4 ist aus einer auf der Leiterplatte 1 aufgebrachten Kupferschicht mit einem Überzug aus Zinn gebildet.

Der Kontaktträger mit dem Gegenkontakt ist der Übersichtlichkeit halber nicht dargestellt. Es kann sich entweder um eine zweite Leiterplatte, ein Gehäuse oder einen sonstigen im festen Abstand zur ersten Leiterplatte 1 gehaltenen Gegenstand mit einem darauf befindlichen Gegenkontakt handeln.

Die Kontaktbrücke 2 ist in einer beispielhaften Ausführung soweit dargestellt, wie dies für die Erläuterung der erfindungsgemäßen Anordnung erforderlich ist. Die Ausführung des nicht dargestellten Abschnitts kann in derselben Weise oder beispielsweise als Löt- oder Steckverbindung ausgeführt sein. Die nicht dargestellte Verbindung zwischen Kontaktbrücke 2 und Gegenkontakt erfolgt demnach durch Löten, Stecken, Klemmen etc. oder aber durch eine erfindungsgemäße Verbindung mittels Verschraubung.

Die Kontaktbrücke 2 besteht aus einem Kunststoffteil 6 und beispielsweise zwei in diesem gehaltenen Drahtelementen 5a, 5b, welche aus blanken oder abisolierten Drähten gebildet sind. Im montierten Zustand sind die auf der Stirnfläche des Kunststoffteils 6 aufliegenden Drahtelementabschnitte auf die mit Zinn überzogene Anschlussfläche 4 gepresst, wodurch eine flächige Auflage der vorzugsweise aus Kupfer bestehenden Drahtelemente entsteht.

Der Kunststoffteil 6 weist längs verlaufende Rillen auf, in welche die geraden Abschnitte der Drahtelemente 5a, 5b eingelegt sind. An der Stirnseite des Kunststoffteils 6 sind ebenfalls rillenförmige Vertiefungen ausgebildet, in welchen die umgebogenen Abschnitte der Drahtelemente 5a, 5b gehalten sind. Bei der Kontaktbrückenherstellung werden die Drahtelemente 5a, 5b im gebotenen Zustand unter elastischer Verformung in die rillenförmigen Vertiefungen des Kunststoffteils 6 eingeschnappt und auf diese Weise sicher im Kunststoffteil 6 gehalten.

Die Form des Kunststoffteils 6 ist an geometrische und befestigungstechnische Anforderungen eines Gerätes anpassbar, beispielsweise durch gebogene Ausführungen oder durch die Anordnung zusätzlicher Rippen. Auch die Anzahl und Dicke der Drahtelemente 5a, 5b ist entsprechend dem zu übertragenden Strom wählbar.

Es ist dabei darauf zu achten, dass die auf der Stirnseite des Kunststoffteils 6 aufliegenden Drahtelementabschnitte über die Stirnfläche des Kunststoffteils 6 hinausragen und so angeordnet sind, dass diese Drahtelementabschnitte im montierten Zustand zwischen der Anschlussfläche 4 der Leiterplatte 1 und der Stirnfläche des Kunststoffteils 6 eingeklemmt sind. Bei nur einem Drahtelement ist auf der Stirnseite des Kunststoffteils 6 ein zusätzlicher Auflagefortsatz vorzusehen, welcher im montierten Zustand gemeinsam mit dem Drahtelement eine Mehrpunktauflage auf der Anschlussfläche 4 bildet.

Die Drahtelemente 5a, 5b können im nicht dargestellten Abschnitt der Kontaktbrücke 2 in gleicher Weise gehalten sein. Die Drahtelemente 5a, 5b können aber beispielsweise auch als längere Drähte weitergeführt sein, welche über den Kunststoffteil 6 hinausragen und als flexible Drähte zum Gegenkontakt geführt sind.

Die in der Figur dargestellte Verschraubung wird aus einer für Kunststoff geeigneten Schraube 3, einer Bohrung 10 in der Leiterplatte 1 und einer Bohrung 8 in der Stirnfläche des Kunststoffteils 6 gebildet. Im montierten Zustand ist die Schraube 3 durch die Bohrung 10 der Leiterplatte 1 geführt und in der Bohrung 8 des Kunststoffteils 6 gehalten. Der Durchmesser der Bohrung 8 im Kunststoffteil 6 ist demnach entsprechend geringer als der Gewindedurchmesser der Schraube 3.

Um zu verhindern, dass sich die Kontaktbrücke 2 während des Montagevorgangs um die Schraubenachse dreht, ist eine Arretierung vorgesehen. Diese besteht aus einem Fortsatz 7, welcher aus der Stirnfläche des Kunststoffteils 6 herausragt und in einem Loch 9 der Leiterplatte 1 gehalten ist.

## Patentansprüche

1. Anordnung einer Leiterplatte (1) und einem dazu in einem festen Abstand gehaltenen Kontaktträger, bei welcher eine dem Kontaktträger zugewandte Anschlussfläche (4) der Leiterplatte (1) mit einem an dem Kontaktträger ausgebildeten Gegenkontakt mittels einer Kontaktbrücke (2) elektrisch leitend verbunden ist, wobei die Kontaktbrücke (2) als Kunststoffteil (6) mit wenigstens einem von diesem Kunststoffteil (6) gehaltenen Drahtelement (5a, 5b) ausgebildet ist, **dadurch gekennzeichnet, dass** das wenigstens eine Drahtelement (5a, 5b) außen am Kunststoffteil gehalten ist, indem ein auf einer Stirnfläche des Kunststoffteils (6) aufliegendes Ende des Drahtelements (5a, 5b) in eine entsprechende Vertiefung auf der Stirnfläche des Kunststoffteils (6) eingeschnappt ist und dass des Weiteren der Kunststoffteil (6) mit der Leiterplatte (1) in der Weise mittels einer Verschraubung verbunden ist, dass das Ende des wenigstens einen Drahtelements (5a, 5b) zwischen Stirnfläche des Kunststoffteils (6) und Anschlussfläche (4) der Leiterplatte (1) geklemmt ist.

2. Anordnung nach Anspruch 1, **dadurch gekennzeichnet, dass** der Kontaktträger als zweite Leiterplatte ausgebildet ist.

3. Anordnung nach Anspruch 1, **dadurch gekennzeichnet, dass** der Kontaktträger als Gehäuse ausgebildet ist.

4. Anordnung nach einem der Ansprüche 1 bis 3, **dadurch gekennzeichnet, dass** versetzt zur Symmetrieachse der Verschraubung aus der Stirnfläche des Kunststoffteils (6) ein Fortsatz (7) herausragt, welcher in einer Bohrung (9) der Leiterplatte (1) gehalten ist.

5. Anordnung nach einem der Ansprüche 1 bis 4, **dadurch gekennzeichnet, dass** die Verschraubung in der Weise ausgebildet ist, dass im Bereich der Anschlussfläche (4) der Leiterplatte (1) eine Schraube (3) durch die Leiterplatte (1) geführt ist und in eine an der Stirnseite des Kunststoffteils (6) angeordnete Bohrung (8) geschraubt ist.

6. Anordnung nach einem der Ansprüche 1 bis 5, **dadurch gekennzeichnet, dass** die Anschlussfläche (4) der Leiterplatte (1) mit Zinn überzogen ist.

7. Anordnung nach einem der Ansprüche 1 bis 6, **dadurch gekennzeichnet, dass** die Verbindung der Kontaktbrücke (2) mit der Leiterplatte (1) und die Verbindung der Kontaktbrücke (2) mit dem Kontaktträger gleichartig ausgebildet sind.

## Claims

1. Arrangement of a printed circuit board (1) and a contact support held at a fixed distance therefrom, in which arrangement a connecting surface (4) of the printed circuit board (1) that faces towards the contact support is connected by means of a contact bridge (2) in an electrically conductive manner to a mating contact embodied on the contact support, wherein the contact bridge (2) is embodied as a plastic part (6) having at least one wire element (5a, 5b) held by said plastic part (6), **characterised in that** the at least one wire element (5a, 5b) is held externally on the plastic part (6) whereby an end of the wire element (5a, 5b) bearing on an end face of the plastic part (6) is snap-fitted into a corresponding recess on the end face of the plastic part (6) and **in that** in addition the plastic part (6) is joined to the printed circuit board (1) by means of a screwed connection in such a way that the end of the at least one wire element (5a, 5b) is clamped between the end face of the plastic part (6) and the connecting surface (4) of the printed circuit board (1).

2. Arrangement according to claim 1, **characterised in that** the contact support is embodied as a second printed circuit board.

3. Arrangement according to claim 1, **characterised in that** the contact support is embodied as a housing.

4. Arrangement according to one of claims 1 to 3, **characterised in that** an extension (7) projects from the end face of the plastic part (6) offset to the axis of symmetry of the screwed connection, said extension being held in a drilled hole (9) in the printed circuit board (1).

5. Arrangement according to one of claims 1 to 4, **characterised in that** the screwed connection is embodied in such a way that a screw (3) is passed through the printed circuit board (1) in the region of the connecting surface (4) of the printed circuit board (1) and is screwed into a drilled hole (8) disposed on the front face of the plastic part (6).

6. Arrangement according to one of claims 1 to 5, **characterised in that** the connecting surface (4) of the printed circuit board (1) is coated with tin.

7. Arrangement according to one of claims 1 to 6, **characterised in that** the connection of the contact bridge (2) to the printed circuit board (1) and the connection of the contact bridge (2) to the contact support are embodied in a similar way.

## Revendications

1. Agencement d'une plaque de circuits imprimés (1) et d'un support de contact maintenu à une distance fixe de celui-ci, sur lequel une surface de raccordement (4), tournée vers le support de contact, de la plaque de circuits imprimés (1) est reliée de façon électroconductrice à un contre-contact conçu sur le support de contact au moyen d'un pont de contact (2), le pont de contact (2) étant conçu sous forme de partie plastique (6) avec au moins un élément de fil (5a, 5b) tenu par cette partie plastique (6), **caractérisé en ce que** l'au moins un élément de fil (5a, 5b) est maintenu à l'extérieur sur la partie plastique par le fait qu'une extrémité, reposant sur une surface avant de la partie plastique (6), de l'élément de fil (5a, 5b) est encliquetée dans une cavité appropriée sur la surface frontale de la partie plastique (6) et **en ce que** également la partie plastique (6) est reliée à la plaque de circuits imprimés (1) au moyen d'un assemblage vissé en ce sens que l'extrémité du au moins un élément de fil (5a, 5b) est coincé entre la surface frontale de la partie plastique (6) et la surface de raccordement (4) de la plaque de circuits imprimés (1).

2. Agencement selon la revendication 1, **caractérisé en ce que** le support de contact est conçu sous forme de seconde plaque de circuits imprimés.

3. Agencement selon la revendication 1, **caractérisé en ce que** le support de contact est conçu comme boîtier.

4. Agencement selon l'une quelconque des revendications 1 à 3, **caractérisé en ce qu'**un appendice (7), qui est maintenu dans un perçage (9) de la plaque de circuits imprimés (1), dépasse de la surface frontale de la partie plastique (6) de façon décalée par rapport à l'axe de symétrie de l'assemblage vissé.

5. Agencement selon l'une quelconque des revendications 1 à 4, **caractérisé en ce que** l'assemblage vissé est conçu de façon que, dans la zone de surface de raccordement (4) de la plaque de circuits imprimés (1), une vis (3) est guidée à travers la plaque de circuits imprimés (1) et est vissée dans un perçage (8) disposé sur la face frontale de la partie plastique (6).

6. Agencement selon l'une quelconque des revendications 1 à 5, **caractérisé en ce que** la surface de raccordement (4) de la plaque de circuits imprimés (1) est recouverte d'étain.

7. Agencement selon l'une quelconque des revendications 1 à 6, **caractérisé en ce que** la liaison du pont de contact (2) avec la carte de circuits imprimés (1) et la liaison du pont de contact (2) avec la surface de contact sont conçues de la même façon.
